# EUROPEAN PATENT APPLICATION

(11) **EP 4 287 800 A1**
(43) Date of publication of application: **06.12.2023**
(21) Application number: 22770336.0
(22) Date of filing: 07.03.2022
(51) Int. Cl.: H05K 7/20

(54) **HEAT DISSIPATION ASSEMBLY, HOUSING ASSEMBLY, AND ELECTRONIC DEVICE**

(30) Priority: 19.03.2021 CN 202110295125; 19.03.2021 CN 202120570984 U
(71) Applicant: GUANGDONG OPPO MOBILE TELECOMMUNICATIONS CORP., LTD., Dongguan, Guangdong 523860 (CN)
(72) Inventor: GE, Yunfei, Dongguan, Guangdong 523860 (CN); WANG, Guohui, Dongguan, Guangdong 523860 (CN)
(74) Representative: Novagraaf Technologies
(86) International application number: PCT/CN2022/079572
(87) International publication number: WO 2022/193981

(57) **Abstract**

A heat dissipation assembly, a housing assembly, and an electronic device are provided in the present disclosure. The heat dissipation assembly includes: a liquid-cooling plate having a coolant flow path inside the liquid-cooling plate, with a cooling fluid sealed inside the coolant flow path, the liquid-cooling plate having a coolant inlet and a coolant outlet in communication with the coolant flow path; a piezoelectric ceramic pump provided on the liquid-cooling plate and communicated with the coolant flow path, the piezoelectric ceramic pump having a pump-in port connected to the coolant outlet, and a pump-out port connected to the coolant inlet.

## Description

### TECHNICAL FIELD

The present disclosure relates to the technical field of heat dissipation for an electronic device, and specifically to a heat dissipation assembly, a housing assembly, and an electronic device.

### BACKGROUND ART

With the continuous improvement of Internet technology, electronic devices are becoming an increasingly important part of people's daily lives. Although the widespread popularity of electronic devices has led to an increasing variety of design patterns, it is still not sufficient to meet the increasingly diverse needs of people. In recent years, the functional requirements for consumer electronic products have become more and more obvious, and in the design of products, engineers may stack a large number of modules/structures to meet the needs of users in order to further increase the functionality of products. However, with the increasing modules/structures inside electronic devices, power consumption of the electronic devices is also gradually increasing. Electronic devices in the prior art can meet the heat dissipation requirements of products by means of passive heat dissipation (natural convection). However, with a further increase in the power of electronic devices, it is difficult to meet the temperature rise requirements of products through natural convection while maintaining a size of the electronic devices unchanged, which in turn reduces the performance of the electronic products and brings about an unfriendly user experience.

Therefore, there is still a need to improve the existing heat dissipation assembly, housing assembly, and electronic device.

### SUMMARY OF THE INVENTION

The present application is intended to alleviate or solve, at least to some extent, at least one of the above mentioned problems.

In one aspect of the present application, the application proposes a heat dissipation assembly including: a liquid-cooling plate having a coolant flow path inside the liquid-cooling plate, with a cooling fluid sealed inside the coolant flow path, the liquid-cooling plate having a coolant inlet and a coolant outlet in communication with the coolant flow path; and, a piezoelectric ceramic pump provided on the liquid-cooling plate and communicated with the coolant flow path, the piezoelectric ceramic pump having a pump-in port connected to the coolant outlet, and a pump-out port connected to the coolant inlet.

In a further aspect of the present application, the application proposes a housing assembly including: a liquid-cooling plate including a first cover body and a second cover body with a coolant flow path there-between, a cooling fluid being sealed inside the coolant flow path, the liquid-cooling plate having a coolant inlet and a coolant outlet in communication with the coolant flow path; and, a piezoelectric ceramic pump provided on the liquid-cooling plate and communicated with the coolant flow path, the piezoelectric ceramic pump having a pump-in port connected to the coolant outlet, and a pump-out port connected to the coolant inlet.

In a further aspect of the present application, the application proposes an electronic device including: a housing assembly as previously described, the housing assembly defining an electronic device accommodation space; a battery; and a motherboard, wherein the battery and the motherboard are located inside the electronic device accommodation space defined by the housing assembly, the piezoelectric ceramic pump in the housing assembly is electrically connected to the motherboard, and the motherboard is electrically connected to the battery.

### BRIEF DESCRIPTION OF THE DRAWINGS

The foregoing and/or additional aspects and advantages of the present application will be apparent and readily understood from the description of embodiments in conjunction with the accompanying drawings below, wherein:
FIG. 1 shows a schematic structural diagram of a heat dissipation assembly according to an embodiment of the present application;
FIG. 2 shows a schematic structural diagram of a portion of a heat dissipation assembly according to an embodiment of the present application;
FIG. 3 shows a schematic structural diagram of a piezoelectric ceramic pump according to an embodiment of the present application;
FIG. 4 shows a schematic structural diagram of a portion of a heat dissipation assembly according to a further embodiment of the present application;
FIG. 5 shows a partially enlarged view of a heat dissipation assembly according to an embodiment of the present application;
FIG. 6 shows a schematic structural diagram of a portion of a heat dissipation assembly according to a further embodiment of the present application;
FIG. 7 shows a schematic structural diagram of a heat dissipation assembly according to a further embodiment of the present application;
FIG. 8 shows a schematic flow chart of a method for preparing a heat dissipation assembly according to an embodiment of the present application;
FIG. 9 shows a schematic flow chart of a method for preparing a heat dissipation assembly according to a further embodiment of the present application;
FIG. 10 shows a schematic structural diagram of a housing assembly according to an embodiment of the present application;
FIG. 11 shows a schematic structural diagram of a housing assembly according to a further embodiment of the present application;
FIG. 12 shows a schematic structural diagram of a housing assembly according to a further embodiment of the present application;
FIG. 13 shows a schematic structural diagram of a piezoelectric ceramic pump according to an embodiment of the present application;
FIG. 14 shows a schematic structural diagram of a piezoelectric ceramic pump according to a further embodiment of the present application;
FIG. 15 shows a schematic structural diagram of a piezoelectric ceramic pump according to a further embodiment of the present application;
FIG. 16 shows a schematic structural diagram of a piezoelectric ceramic pump according to a further embodiment of the present application;
FIG. 17 shows a schematic structural diagram of a check valve membrane according to an embodiment of the present application.

### DETAILED DESCRIPTION OF THE INVENTION

Embodiments of the present disclosure will be detailed below. The embodiments described below are exemplary and intended only to explain (rather than limit) the present disclosure. Where specific techniques or conditions are not indicated in the embodiments, the embodiments may follow the techniques or conditions described in literature of the art or follow the product's specification.

Related heat dissipation technologies adopting coolant circulation as active cooling have been widely used in data centers, servers, laser displays and other devices. Since coolant has advantages of larger specific heat capacity, more adequate contact with heat-generating devices, faster and controllable flow rate, the heat flux density of coolant circulation heat dissipation can reach more than 100 times of natural convection. Inventors of this application found many difficulties in miniaturization of the coolant circulation heat dissipation, mainly as follows:

Miniaturization of a coolant pump is extremely difficult, and it is difficult to take into account both high flow rate and high pressure head. Insufficient flow rate may lead to a larger thermal resistance caused by a temperature rise of the coolant itself, reducing the heat transfer efficiency; low pressure head makes it difficult for the coolant pump to overcome a resistance of the flow path to the coolant, a main cause of the resistance being the friction of the coolant due to its own viscosity with a wall of the coolant flow path, which in turn leads to insufficient flow rate of the coolant flow path; electronic devices have higher requirements for lightweight and thinness of the liquid-cooling plate. Current liquid-cooling plate is generally made of a material such as aluminum alloy, copper, stainless steel, etc., and has a thickness usually above millimeter level, which brings greater blocks to the thinness and portability of electronic devices; coolant circulation heat dissipation generally adopts external circulation heat dissipation requiring water storage devices, which is unachievable in electronic devices. In addition, miniaturization of coolant circulation heat dissipation also induces other problems difficult to overcome, such as low heat transfer coefficient between the coolant flow path and heat source, larger size of the coolant pump, larger size of the fan, and noise of the fan, which is extremely unfriendly to user experience.

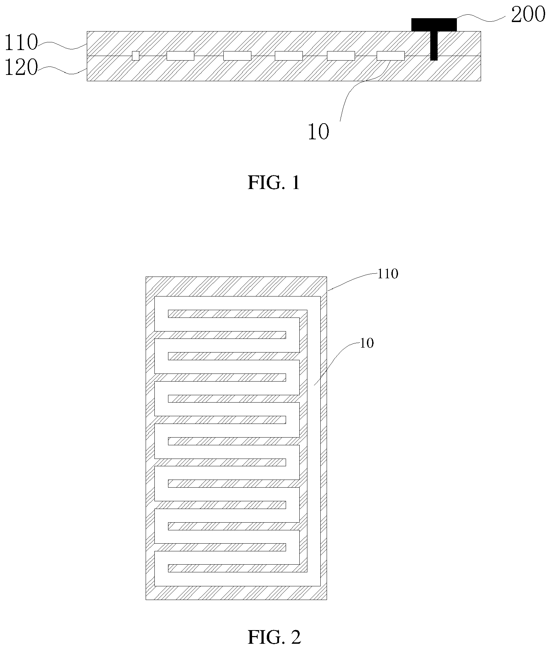

In one aspect of the present application, a heat dissipation assembly is proposed, with reference to FIGS. 1 and 2, which includes: a liquid-cooling plate having a coolant flow path 10 inside the liquid-cooling plate, with a cooling fluid sealed inside the coolant flow path 10, the liquid-cooling plate having a coolant inlet and a coolant outlet in communication with the coolant flow path; a piezoelectric ceramic pump 200 provided on the liquid-cooling plate and communicated with the coolant flow path 10, the piezoelectric ceramic pump 200 having a pump-in port connected to the coolant outlet, and a pump-out port connected to the coolant inlet. As a result, the flow of cooling fluid within the coolant flow path can be accelerated by the piezoelectric ceramic pump, thereby speeding up heat transfer between the cooling fluids and ultimately obtaining a cooling fluid with temperature homogeneity, thus obtaining a heat dissipation assembly with fast heat dissipation, temperature homogeneity, and miniaturized size. According to some embodiments of the application, the liquid-cooling plate includes a first cover body and a second cover body opposite to each other, and the coolant flow path is sealed between the first cover body and the second cover body.

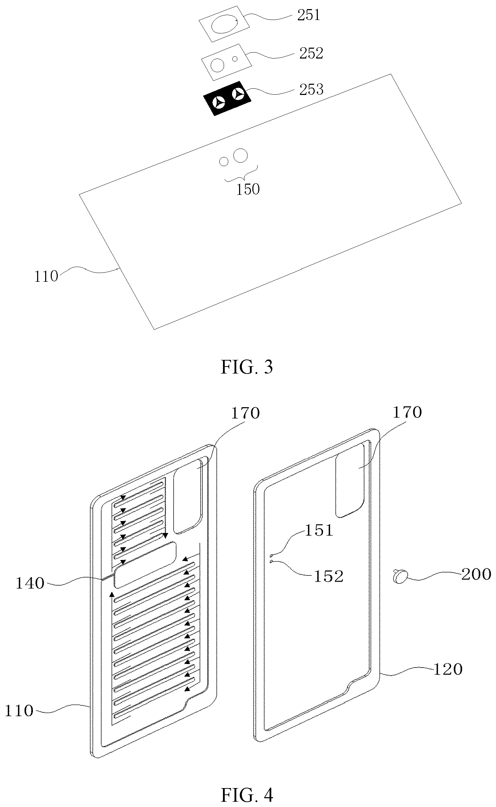

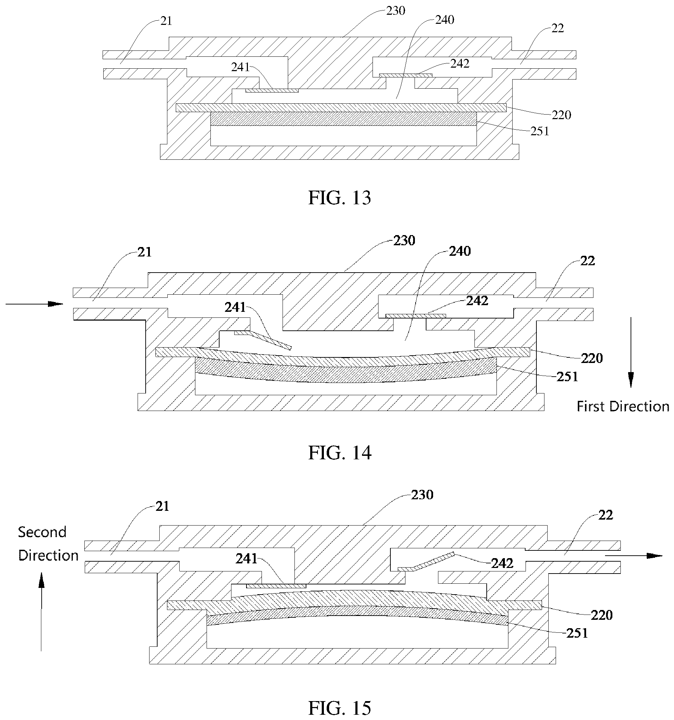

According to some embodiments of the present application, referring to FIG. 3, a structure of the piezoelectric ceramic pump is not particularly limited, e.g., the piezoelectric ceramic pump may include: a piezoelectric diaphragm which includes a piezoelectric ceramic sheet 251 and a support plate in contact with the piezoelectric ceramic sheet, a surface of the piezoelectric ceramic sheet 251 being provided with electrodes capable of generating electric field which controls oscillation of the piezoelectric ceramic sheet 251; and a valve body provided between the piezoelectric diaphragm and the liquid-cooling plate, the valve body being capable of controlling one of the pump-in port and the pump-out port to be open, and the other one to be closed. Since the piezoelectric ceramic pump involves properties of low power consumption, small size and easy assembly, a heat dissipation assembly with better temperature homogeneity can be obtained. According to specific embodiments of the present application, with reference to FIGS. 13 to 15, the piezoelectric ceramic pump may include a piezoelectric diaphragm, a base 230, and a valve body. The piezoelectric diaphragm includes a piezoelectric ceramic sheet 251 and a support plate 220 in contact with the piezoelectric ceramic sheet. A surface of the piezoelectric ceramic sheet is provided with electrodes (not shown in the figures) capable of generating an electric field for controlling oscillation of the piezoelectric ceramic sheet 251. Specifically, the piezoelectric ceramic sheet 251 may have two electrodes on two opposite surfaces, which may make the piezoelectric ceramic sheet be in an electric field when energized. As a result, a controllable oscillation of the piezoelectric ceramic sheet can be achieved to generate power for the flow of cooling fluid. The support plate 220 is located between the piezoelectric ceramic plate and the base 230, for example, the support plate may be a stainless steel plate. A thickness of the support plate can be relatively small, as long as it is sufficient to play a role for supporting the piezoelectric ceramic plate and increasing oscillation amplitude. For example, the support plate and piezoelectric ceramic element may be adjacent to each other, and an overall thickness of the two can be about 0.2 mm. The base 230 is located on one side of the support plate away from the piezoelectric ceramic sheet, and specifically may include a side wall surrounding the support plate and a bottom surface connected with the side wall. The bottom surface may have a pump-in port 21 and a pump-out port 22, that is, the pump-in port and pump-out port are located on a surface of the base away from the support plate. Thereby, the base defines a fluid accommodation space 240 between a bottom surface where the pump-in port and pump-out port are located, and the support plate, so that oscillation of the piezoelectric ceramic plate on the other side of the fluid accommodation space can provide power for pumping in and out the fluid in the fluid accommodation space. That is, the base needs to define a cavity for the piezoelectric ceramic pump, and an overall thickness of the base may be about 2 mm. The valve body is provided inside the fluid accommodation space and can be cyclically controlled to open one of the pump-in port and the pump-out port while closing the other one, when the piezoelectric diaphragm oscillates. A specific structure of the valve body is not particularly limited, as long as the cyclic control can be achieved to pump in and out the cooling liquid in the fluid accommodation space. For example, referring to FIGS. 13 to 15, the valve body may include two check valves (such as 241, 242 shown in the figures) set in a second direction, wherein the cover body is located at the pump-in port and the pump-out port, two cover bodies open in opposite directions, and the cover body fully covers an opening communicated to the pump-in port and the pump-out port. Thereby, when the piezoelectric ceramic sheet oscillates in a first direction, the cover body opening toward the first direction is open and the cover body opening toward the second direction is closed. In the next oscillation of the piezoelectric ceramic plate, i.e., when oscillation in the second direction occurs, the cover body opening towards the first direction is closed and the cover body opening towards the second direction is open. As a result, a fluid can be pumped into the fluid accommodation space from the pump-in port and out of the accommodation space from the pump-out port, thereby achieving circulation of the coolant. Directions of entry and exit of the coolant is shown by the arrows in FIGS. 14 and 15.

According to other embodiments of the present application, referring to FIGS. 3, 16 and 17, the valve body may be located directly on the liquid-cooling plate. A construction of the valve body is not particularly limited, and a check valve membrane 253 is configured to oscillate with oscillation of the piezoelectric ceramic sheet 251. Other parts of the valve body have through-holes corresponding to the coolant inlet and coolant outlet. The through-holes together with the skeletonized area 2531 in the check valve membrane 253 can sequentially control the coolant inlet to be open and the coolant outlet to be closed, or alternatively control the coolant outlet to be open and the coolant inlet to be closed, thus achieving pumping in and out of the coolant.

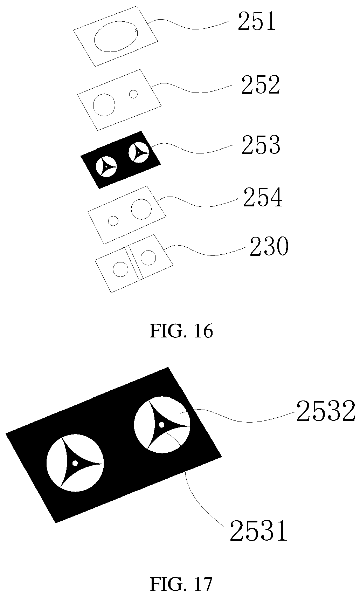

Specifically, referring to FIGS. 16 and 17, the valve body may include a check valve upper cover 252, a check valve membrane 253, and a check valve lower cover 254. The piezoelectric ceramic pump may further include a base 230 to provide a space for coolant circulation inside the piezoelectric ceramic pump. The check valve lower cover 254 may also have two through-holes, i.e., a larger through-hole and a smaller through-hole. The location of through-hole in the check valve upper cover 252 is consistent with that of through-hole in the check valve lower cover 254. A projection of the larger through-hole in the check valve upper cover 252 on the check valve lower cover 254 is at the smaller through-hole in the check valve lower cover 254, and a projection of the smaller through-hole in the check valve upper cover 252 on the check valve lower cover 254 is at the larger through-hole in the check valve lower cover 254. The check valve membrane 253 can be an elastic film with a thickness of about 0.005 mm, and may have two skeletonized area 2531 of the same shape. Each of the skeletonized areas 2531 has a solid portion 2532, and orthographic projections of the solid portion 2532 on the check valve upper cover 252 and on the check valve lower cover 254 can cover smaller through-holes of the check valve upper cover 252 and the check valve lower cover 254, respectively. The check valve membrane 253 of the valve body can oscillate in the first direction or negative direction with oscillation of the piezoelectric ceramic sheet 251. Thus, when oscillation of the check valve membrane in the first direction occurs, the check valve membrane moves toward the check valve upper cover; at this point, the solid portion blocks smaller through-holes in the check valve upper cover, while larger through-holes are not fully covered, therefore the flow path on the side of larger through-holes of the check valve upper cover are open, while the flow path on the side of smaller through-holes is closed. Conversely, when oscillation of the check valve membrane in the second direction occurs, the check valve membrane moves toward the check valve lower cover; at this point, the solid portion blocks smaller through-holes in the check valve lower cover, while larger through-holes are not fully covered, therefore the flow path on the side of large through-holes of the check valve upper cover is closed, while the flow path on the side of smaller through-holes is open.

Specifically, referring to FIGS. 3 and 17, since the piezoelectric ceramic pump in this embodiment of the present application is directly provided on the liquid-cooling plate, the plate body structure of the liquid-cooling plate may be utilized to support the piezoelectric diaphragm and the valve body, acting as a base for the pump body. Also, the piezoelectric ceramic pump may be further thinned by designing the location and size of the coolant inlet and the coolant outlet. Specifically, for example, the valve body may only include a check valve upper cover 252 and a check valve membrane 253 which may be bonded by means of adhesive. The check valve upper cover 252 includes a first through-hole and a second through-hole, the area of the first through-hole is greater than that of the second through-hole. The check valve membrane 253 is located between the check valve upper cover 252 and the liquid-cooling plate. The check valve membrane 253 is configured to oscillate with oscillation of the piezoelectric ceramic sheet 251, and has two skeletonized areas 2531 of the same shape. Each of the skeletonized areas 2531 has a solid portion 2532, an orthogonal projection of the solid portion 2532 on the check valve upper cover is at the first through-hole and the second through-hole, and orthogonal projections of the first through-hole and second through-hole on the liquid-cooling plate are respectively located at the coolant inlet 151 and the coolant outlet 152. An orthogonal projection of the first through-hole on the liquid-cooling plate fully covers one of the coolant inlet and the coolant outlet 150, an orthogonal projection of the second through-hole on the liquid-cooling plate is located within the other of the coolant inlet and coolant outlet 150, an orthographic projection of the solid portion on the check valve upper cover 252 corresponding to the second through-hole fully covers the second through-hole, and an orthographic projection of the solid portion on the liquid-cooling plate corresponding to the first through-hole fully covers one of the coolant inlet and the coolant outlet 150.

The check valve membrane 253 of the valve body may oscillate in the first direction or negative direction with oscillation of the piezoelectric ceramic plate 251. Thereby, when oscillation of the check valve membrane in the first direction occurs, the check valve membrane moves toward the check valve upper cover; at this point, the solid portion blocks the second through-hole in the check valve upper cover, while the first through-hole is not fully covered, thus the flow path on the first through-hole side of the check valve upper cover is open, and the flow path on the second through-hole side is closed. On the contrary, when oscillation of the check valve membrane in the second direction occurs, the check valve membrane moves toward one side away from the check valve upper cover, i.e., toward the side of the liquid-cooling plate; at this point, the solid portion covers one of the coolant inlet and the coolant outlet on the liquid-cooling plate corresponding to the first through-hole, and the other of the coolant inlet and the coolant outlet on the liquid-cooling plate corresponding to the second through-hole is not fully covered, thus the flow path on the first through-hole side of the check valve upper cover is closed, and the flow path on the second through-hole side is open. Hence, the check valve lower cover (not shown in the figures) and a base of the pump body can be omitted, thereby thinning the piezoelectric ceramic pump.

Specifically, a thickness of the piezoelectric diaphragm of the thinned piezoelectric ceramic pump may be in a range of 0.15-0.25 mm, a thickness of the the check valve upper cover may be in a range of 0.17-0.23 mm, a thickness of the check valve membrane may be in a range of 0.03-0.07 mm, and an overall thickness of the piezoelectric ceramic pump may be in a range of 0.35-0.55 mm.

According to some embodiments of the present application, when the cover body (first cover body or second cover body) on one side of the liquid-cooling plate, where the piezoelectric ceramic pump is arranged, has better elasticity to deform with the piezoelectric ceramic sheet in the piezoelectric ceramic pump, the cover body (first cover body or second cover body) on one side of the liquid-cooling plate, where the piezoelectric ceramic pump is arranged, can be used to act directly as the check valve lower cover, thus facilitating further reduction in an overall thickness of the heat dissipation assembly.

For better understanding, the principle by which the heat dissipation assembly can achieve the above-mentioned beneficial effects will be briefly described in the following.

The liquid-cooling plate, as a heat dissipation assembly for electronic devices, may be used to keep the electronic device at a lower operating temperature by either internal heat equalization or heat exchange with an external cooling source. Through direct contact with the heat source, energy from the heat source passes through a housing of the liquid-cooling plate to the cooling fluid, which is driven by a liquid pump to carry heat to a low-temperature region where it flows, and is carried away from the electronic device by means of natural convection or forced cooling through the housing of the liquid-cooling plate. In the related art, the liquid-cooling plate is usually made of a rigid non-bendable metal. Although the thermal conductivity of metal is high, which is conducive to heat transfer in the liquid-cooling plate, the thinness of portable electronic devices is the most important and significant impact on the human-computer experience, and a volume of the metal liquid-cooling plate is large, so there is no enough space in the electronic device to arrange the liquid-cooling plate, and the metal material may shield and interfere RF antennas of the electronic device, thereby affecting the operation stability of the electronic device.

In the present application, the inventors have adopted a piezoelectric ceramic pump as a driving pump for the cooling fluid. The size of a miniature piezoelectric ceramic pump is smaller than that of a traditional mechanical pump, and the driving power of the piezoelectric ceramic pump is extremely low, usually on the order of tens of milliwatts, due to extremely poor conductivity and extremely low operating current of the piezoelectric ceramic. The small size and low energy consumption facilitate its carriage in electronic devices. Also, the piezoelectric ceramic pump abandons electromagnetic coils in the traditional liquid pump, and does not produce electromagnetic interference to the electronic device, contributing to the improvement in operational stability of the device. In this application, referring to FIGS. 1, 4 and 7, the inventors have machined a coolant flow path 10 directly onto the cover body (first cover body or second cover body) by etching, laser, machining, etc., to form a communicated channel in the cover body (first cover body or second cover body), sealed the cooling fluid (such as water or organic liquid) inside the coolant flow path, and installed the piezoelectric ceramic pump 200 at any position inside the coolant flow path 10 for driving the cooling fluid to flow within the coolant flow path 10, leading to a thinned, low-cost, easy-to-assemble and low-electromagnetic interference housing assembly with better temperature homogeneity.

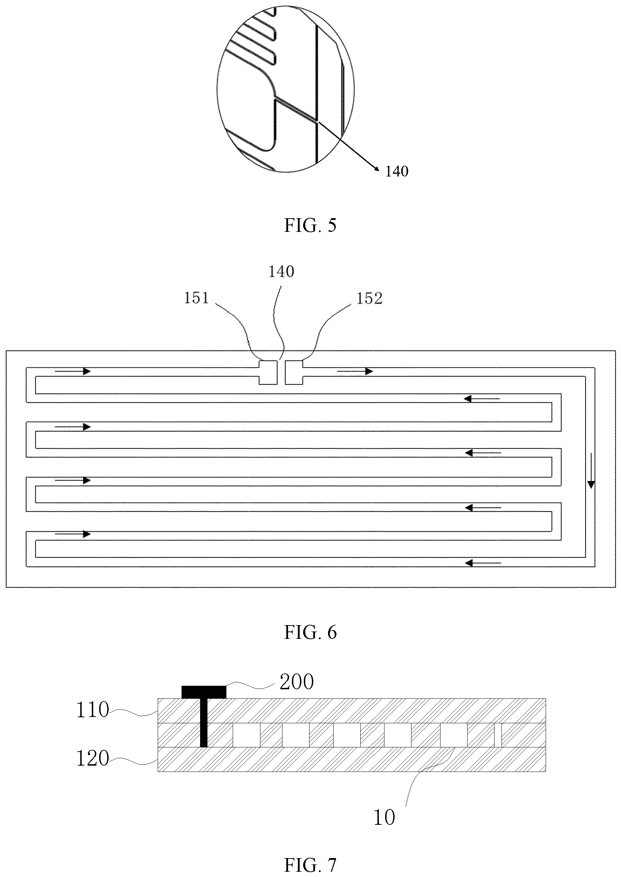

According to some embodiments of the present application, in order to prevent the coolant from directly flowing between the pump-in port and pump-out port without passing through the coolant flow path and short-circuiting the liquid, referring to FIGS. 5 and 6, the coolant flow path may further include a blocking piece 140. The coolant inlet and the coolant outlet are adjacent to each other. The blocking piece 140 is located between the coolant inlet and the coolant outlet, dividing the coolant flow path into a water supply area and a water return area. The water supply area is connected to the coolant inlet on one side, the water return area is connected to the coolant outlet, and the water supply area and the water return area are connected on one side away from the coolant inlet. By dividing the coolant flow path into a water supply area and a water return area through the blocking piece, the coolant flow rate can be accelerated through the arrangement of the piezoelectric ceramic pump, improving temperature homogeneity of the heat dissipation assembly. Specifically, as the liquid-cooling plate has a structure as shown in FIGS. 4-5, the blocking piece 140 may be a spacer rib for separating the coolant inlet from the coolant inlet. That is, the coolant inlet and the coolant outlet may be located on upper and lower sides of the blocking piece 140 illustrated in FIG. 4. Taking an example of the pump outlet near a camera through-hole 170 in FIG. 4, at this point, the coolant pumped-out by the piezoelectric ceramic pump flows in an area of the first cover body near the camera through-hole 170, and as the inlet and outlet are spaced apart here due to the blocking piece 140, the coolant pumped from the pump outlet is not drawn directly into the pump by a pressure of the pump inlet without passing through an upper part of the first cover body. The coolant can flow into a lower part of the first cover body under the camera through-hole 170 and circulate from the pump inlet after flowing through a complete coolant flow path. The flow direction of coolant within the coolant flow path may be as shown by the arrows in FIG. 4.

Alternatively, referring to FIG. 6, the blocking piece 140 may be a gap between the coolant inlet 151 and the coolant outlet 152. The gap may be a projection, also serving to block the coolant pumped out from the pump outlet from passing through an upper part of the first cover body and being drawn directly into the pump by a pressure of the pump inlet. As a result, the coolant flows through the entire coolant flow path before being drawn in by the pump for the next cycle.

Specifically, the flow direction of coolant within the coolant flow path may be as shown by the arrows in FIG. 6.

According to some embodiments of the present application, with reference to FIG. 4 and FIG. 6, the width and arrangement of the coolant flow path are not particularly limited, for example, the coolant flow path can be S-shaped, and the coolant flow direction is shown by arrows in the figures. When the water supply area and water return area are both S-shaped, the cooling fluid has the longest flow path in the corresponding area, so the heat exchanging time between the fluids is the longest and the heat exchange effect is the best, which helps obtain a cooling fluid with uniform temperature, further improving temperature homogeneity of the heat dissipation assembly.

According to some embodiments of the present application, a depth of the coolant flow path is not particularly limited, for example, the depth of the coolant flow path may not be less than 25 microns. When the depth of the coolant flow path is less than 25 microns, a volume of the cooling fluid in the coolant flow path is small, and the cooling effect is not sufficient to meet the use requirements.

According to some embodiments of the present application, in order to ensure that the piezoelectric ceramic pump has a sufficient pressure head to create a coolant flow rate enough to dissipate heat, a volume of the piezoelectric ceramic pump and the coolant flow path is not particularly limited, for example, the volume of the piezoelectric ceramic pump and the coolant flow path may be configured so that the coolant flow rate in the coolant flow path is not less than 0.5 mL/min. When the coolant flow rate in the coolant flow path is less than 0.5 mL/min, the coolant (e.g., water) will not be able to effectively dissipate heat from the heat source. Specifically, the inventors have found that at least one of a thickness H and a diameter D of the piezoelectric ceramic sheet in the piezoelectric ceramic pump needs to meet the conditions of: 0.1mm < H < 0.5mm; 3mm ≤ D ≤ 12mm. Specifically, the piezoelectric ceramic sheet can oscillate under an electric field, and the mechanical oscillation can provide power for the flow of coolant. Conventional piezoelectric ceramic sheet is a sheet with upper and lower surfaces coated with conductive material (for formation of electrodes), where the material and size of the piezoelectric ceramic sheet determines the power that can be provided by the piezoelectric ceramic pump. Specific material of the piezoelectric ceramic sheet is not particularly limited, for example, it can be zirconium-based ceramic. It is understood by those skilled in the art that the area of the heat dissipation assembly cannot be too small for an electronic device to effectively equalize heat from a heat source to an area outside the heat source, i.e., the size of the heat dissipation assembly shall cover at least one heat source in the electronic device, and a sufficiently large area outside the heat source. The inventors have found that for the volume of commonly used electronic devices (e.g., mobile terminals such as cell phones, PADs, and laptops), a piezoelectric ceramic sheet with a thickness of not less than 0.1 mm and not more than 0.5 mm and a diameter of not less than 3 mm and not more than 12 mm can provide sufficient power for the heat dissipation assembly, while ensuring that a flow rate of the coolant sealed inside the heat dissipation assembly is not less than 0.5 mL/min, and that the heat dissipation assembly is of moderate volume and weight, and can be placed in the electronic device relatively simply.

According to some embodiments of the present application, to enhance buffering effect of the fluid at the pump-out port, the coolant flow path adjacent to the coolant inlet and the coolant outlet may have a buffer section, and a width of the buffer section can be greater than a width of the coolant flow path at the non-buffer sections.

That is, the pumped-out or pumped-in fluid can be further buffered by increasing a cross-sectional area (i.e., in the width direction) of the coolant flow path at a junction of the pump-in or pump-out ports of the piezoelectric ceramic pump with the first or second cover bodies. Specifically, the width of the buffer section can be at least two times the width of the coolant flow path at the non-buffer sections.

According to some embodiments of the present application, referring to FIG. 1, the liquid-cooling plate includes a first cover body 110 and a second cover body 120 opposite to each other, and the coolant flow path 10 is sealed between the first cover body 110 and the second cover body 120. The materials forming the first cover body and the second cover body are not particularly limited, for example, the materials of the first cover body and the second cover body may include at least one of polyester, polyimide, polymethyl methacrylate, polyethylene, polyvinyl chloride, polystyrene, ceramic, and glass, respectively. For example, both the first cover body and the second cover body may be rigid cover bodies, and when the material of the first cover body and the second cover body is at least one of plastic and glass, plastic and glass materials are more malleable, facilitating preparation of the heat dissipation assembly with different morphology and further improvement in the applicability of the heat dissipation assembly. After the aforementioned heat dissipation assembly with temperature homogeneity is obtained, the heat dissipation assembly can be directly attached to a cover body of the existing electronic device, i.e., as an external heat dissipation assembly attached to a cover body of the electronic device, which helps further improve applicability of the heat dissipation assembly, and the external heat dissipation assembly can avoid cooling fluid from vaporizing and entering the electronic device, leading to water ingress and damage to the electronic components inside the electronic device. When the material forming the first cover and the second cover is the aforementioned organic material, the first cover and the second cover have better resistance to bending, which helps to reduce the processing difficulty of the heat dissipation assembly and improve its applicability.

According to some embodiments of the present application, formation of a coolant flow path between the first cover body and the second cover body, and a specific shape of the coolant flow path are not particularly limited, as long as a coolant can be sealed and circulated with the power provided by the piezoelectric ceramic pump. For example, referring to FIG. 1, the first cover body 110 may have a first recess on one side facing the second cover body 120, the second cover body 120 may have a second recess on one side facing the first cover body 110, and the first recess and the second recess form the coolant flow path 10; that is, both the first cover body and the second cover body may have non-penetrating recesses, the first recess and the second recess have the same shape, and the two are sealed together to form a coolant flow path. Meanwhile, the first cover body or the second cover body may have a through-hole penetrating the cover body, which is in communication with the coolant flow path formed by the first recess and the second recess, and the through-hole forms the coolant inlet and the coolant outlet, the piezoelectric ceramic pump is set on the cover body with the through-hole of the liquid-cooling plate. According to some embodiments of the present application, a thickness of the first cover body at the first recess and a thickness of the second cover body at the second recess are independently not less than 25 microns.

According to some embodiments of the present application, formation of a coolant flow path between the first cover body and the second cover body, and a specific shape of the coolant flow path are not particularly limited, as long as a coolant can be sealed and circulated with the power provided by the piezoelectric ceramic pump. For example, referring to FIG. 4, one of the first cover body 110 and the second cover body 120 may have a recess on a surface, and the recess and the other of the first cover body 110 and the second cover body 120 form a coolant flow path.

According to some embodiments of the present application, referring to FIG. 7, formation of the coolant flow path 10 between the first cover body 110 and the second cover body 120, and a specific shape of the coolant flow path 10 are not particularly limited, as long as the coolant can be sealed and circulated with the power provided by the piezoelectric ceramic pump 200. For example, a spacer may be provided between the first cover body and the second cover body, and has a skeletonized pattern which constitutes the coolant flow path. The first cover body or the second cover body has two through-holes penetrating the cover body, which are communicated with the coolant flow path formed by the skeletonized pattern, and the through-holes form the coolant inlet and the coolant outlet. According to some embodiments of the present application, the material forming the spacer may be the same as that forming the first cover body or the second cover body, i.e., the material forming the spacer may be at least one of polyester, polyimide, polymethyl methacrylate, polyethylene, polyvinyl chloride, polystyrene, ceramic, and glass.

As mentioned above, the material forming the first cover body, the second cover body and the spacer is not particularly limited, and may independently include at least one of polyester, polyimide, polymethyl methacrylate, polyethylene, polyvinyl chloride, polystyrene, ceramic, and glass, respectively, so that the liquid-cooling plate formed by sealing the first cover body with the second cover body, or the liquid-cooling plate formed by sealing the first cover body, the second cover body and the spacer can result in a rigid liquid-cooling plate or a flexible liquid-cooling plate, depending on the materials as used. That is, the heat dissipation assembly formed by a combination of the liquid-cooling plate and the piezoelectric ceramic pump can be either rigid or flexible.

According to some embodiments of the present application, when the material forming at least one of the first cover body and the second cover body is a flexible material, i.e., at least one of the first cover body and the second cover body is formed by a flexible material, the heat dissipation assembly may further include a water-oxygen barrier film, which is located on one side of the cover body formed by the flexible material away from the coolant flow path. Specifically, the aforementioned flexible material may be a polymer material.

For better understanding, a method for preparing the heat dissipation assembly as described above in the present application will be briefly described below in conjunction with specific embodiments. The method includes: providing a liquid-cooling plate having a coolant flow path inside the liquid-cooling plate, with a cooling fluid sealed inside the coolant flow path, the liquid-cooling plate having a coolant inlet and a coolant outlet in communication with the coolant flow path; providing a piezoelectric ceramic pump on one side of the liquid-cooling plate, the piezoelectric ceramic pump being communicated with the coolant flow path and having a pump-in port connected to the coolant outlet and a pump-out port connected to the coolant inlet. Thus, the foregoing liquid-cooling plate can be easily obtained.

Specifically, the method may include the following operational steps:
S 100: providing a liquid-cooling plate;
According to some embodiments of the present application, a liquid-cooling plate is provided in this step. As mentioned above, the material and structure for forming the liquid-cooling plate are not particularly limited, as long as a sealed and communicated coolant flow path is formed inside the liquid-cooling plate.

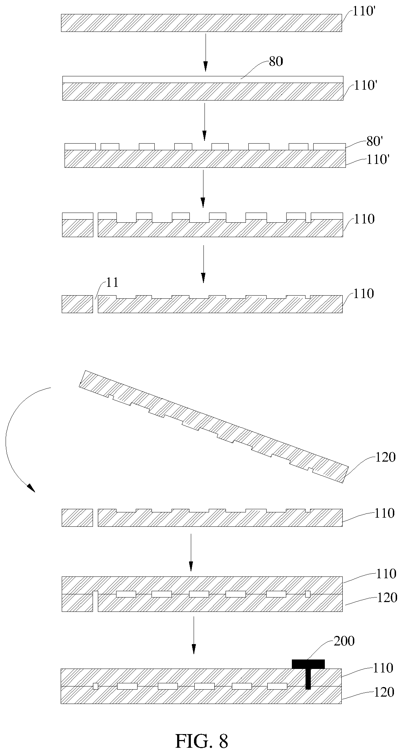

According to some embodiments of the present application, with reference to FIG. 8, the step of providing a liquid-cooling plate may include: first, forming a first recess on one side of a first cover body and forming a second recess on one side of a second cover body. The materials for the first cover body and the second cover body have been described in detail earlier and will not be repeated here. In particular, since the first cover body and the second cover body need to be sealed together in a subsequent process to create an airtight space, it is necessary that the first cover body and the second cover body have the same area. Specifically, the first recess and the second recess can be formed by etching a cover body, and specifically, the etching process can include, but is not limited to, photolithography, laser, direct writing, etc. Taking the first cover body as an example, the second cover body may be prepared in a similar way as the first cover body, for example, a barrier layer 80 may be formed on a surface of the cover body by spin coating, spraying or laminating, and subsequently the barrier layer 80 may be etched by photolithography, laser, direct writing, etc., so that the etched barrier layer 80' covers a partial surface of the plate 110' for forming the first cover and exposes a location where a recess is to be formed. Removal depth can be precisely controlled so that either a first recess or a second recess can be formed. This step may further include an operation of forming a through-hole 11 on the cover body, for example, two through-holes may be formed, and the through-holes may constitute a coolant inlet and a coolant outlet in communication with the coolant flow path (not shown in the figures).

After etching, the first cover body or the second cover body may be obtained by cleaning and removing the remaining barrier layer from a surface of the cover body. The first recess and the second recess can be formed in the same way, and then the first and second cover bodies can be aligned and sealed by an alignment mark or an alignment machine. For the cover body formed of a plastic material, e.g., a polymer material, the sealing process can be chosen from a solder-less welding such as thermal bonding, laser sealing welding, or an inter-facial agent sealing, such as gluing, inter-layer bonding. After the sealing and a leak test are completed, a plate body with temperature homogeneity can be obtained.

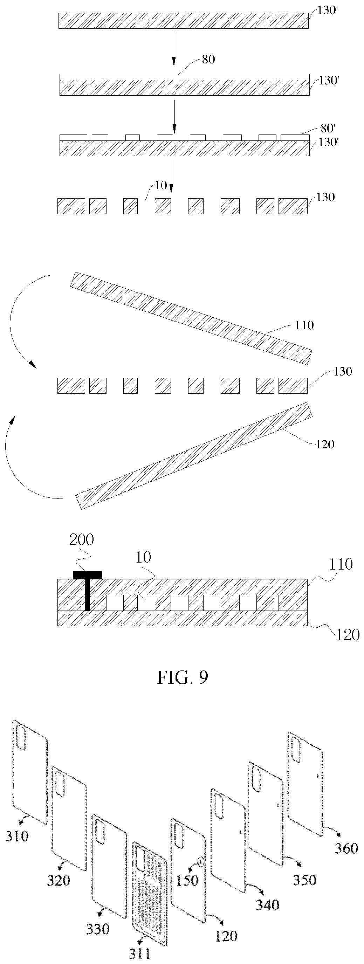

Alternatively, referring to FIG. 9, instead of forming recesses in the first cover body and the second cover body, a spacer is provided with a skeletonized pattern on the basis of which a coolant flow path is formed. Specifically, the spacer 130 can be obtained by first etching the material forming the barrier layer 80 and then using the etched barrier layer 80' to form a skeletonized pattern penetrating a plate material 130' of the spacer, thereby obtaining the spacer 130. The skeletonized pattern is an interconnected curved pattern. The operation of etching the spacer may be the same as the previous operation of forming the first recess and the second recess, except that etching of the spacer can be performed without controlling the etching depth, as long as a skeletonized pattern penetrating the spacer is formed. Subsequently, the through-holes penetrating the cover body can be formed in the first cover body or the second cover body to form the coolant inlet and the coolant outlet. Finally, the spacer is sealed between the first cover body and the second cover body to form the liquid-cooling plate. At this point, a thickness of the spacer is equal to a depth of the coolant flow path, so the depth of the coolant flow path as formed can be controlled by controlling the thickness of the spacer.

S200: providing a piezoelectric ceramic pump on one side of the liquid-cooling plate;
According to some embodiments of the present application, in this step, the piezoelectric ceramic pump is arranged on one side of the liquid-cooling plate. Specifically, the piezoelectric ceramic pump can be installed at an interface reserved on the liquid-cooling plate, i.e., at the coolant inlet and the coolant outlet, and the interface is sealed by means of dispensing, fusing, etc. The structure and operation of the piezoelectric ceramic pump have been described in detail, and will not be repeated here.

As a result, the aforementioned heat dissipation assembly can be obtained easily. This method can obtain a heat dissipation assembly with a thinner overall thickness, and designs of the piezoelectric ceramic pump and the liquid-cooling plate can ensure that the coolant inside the liquid-cooling plate may have a certain flow rate to meet the requirements for temperature homogeneity and heat dissipation. Moreover, the processing method of the liquid-cooling plate is simple and the production cost is relatively low, thus facilitating the preparation in large-size and large-scale.

In a further aspect of the present application, the application proposes a housing assembly including: a liquid-cooling plate including a first cover body and a second cover body defining a coolant flow path there-between, with a cooling fluid sealed inside the coolant flow path, the liquid-cooling plate having a coolant inlet and a coolant outlet in communication with the coolant flow path; a piezoelectric ceramic pump provided on the liquid-cooling plate and communicated with the coolant flow path, the piezoelectric ceramic pump having a pump-in port connected to the coolant outlet and a pump-out port connected to the coolant inlet. Thus, the piezoelectric ceramic pump can accelerate the flow of the cooling fluid in the coolant flow path, thereby accelerating heat transfer between the cooling fluids and finally obtaining a cooling fluid with temperature homogeneity, and further a housing assembly with rapid heat dissipation, temperature homogeneity and miniaturized size.

According to some embodiments of the present application, the housing assembly is applicable in an electronic device, and a structure of the first cover body is not particularly limited, referring to FIG. 4, the first cover body 110 may be a rear cover of an electronic device, such as a glass rear cover. Alternatively, referring to FIG. 10, the first cover body 110 may include, for example, an electronic device rear cover 310 and a first membrane 311 with a coolant flow path defined between the first membrane 311 and the second cover body 120. Specifically, the electronic device cover body 310 may be a glass rear cover. According to some embodiments of the present application, referring to FIG. 10, a structure of the housing assembly is not particularly limited, for example, the housing assembly may further include at least one of the following structures: a first water-oxygen barrier membrane 330 located on one side of the first membrane 311 away from the second cover body 120; a second water-oxygen barrier membrane 340 located on one side of the second cover body 120 away from the first membrane 311; a decorative layer 360 located on one side of the second cover body 120 away from the first cover body. Specifically, the decorative layer may include at least one of the following structures: a texture sub-layer, a coating sub-layer, a color sub-layer, and a bottom ink sub-layer.

Specifically, the housing assembly may include only a first water-oxygen barrier membrane; the housing assembly may include only a second water-oxygen barrier membrane; the housing assembly may include only a decorative layer; the housing assembly may include only the first water-oxygen barrier membrane and the second water-oxygen barrier membrane; the housing assembly may include only the first water-oxygen barrier membrane and the decorative layer; the housing assembly may include only the second water-oxygen barrier membrane and the decorative layer; the housing assembly may include the first water-oxygen barrier film, the second water-oxygen barrier film and the decorative layer. Other structures in the housing assembly are not particularly limited, and can be selected by those skilled in the art according to actual situations.

Specifically, when the housing assembly further includes the first water-oxygen barrier film, the second water-oxygen barrier film and the decorative layer, referring to FIG. 10, the housing assembly may include: a first bonding layer 320 located on one side of the electronic device rear cover 310 facing the first membrane 311; a first water-oxygen barrier film 330 located on one side of the first membrane 311 away from the second cover body 120, with a coolant flow path defined between the first membrane 311 and the second cover body 120, the first membrane 311 and the second cover body 120 being located on one side of the first water-oxygen barrier film 330 away from the first bonding layer 320, the first membrane 311 and second cover body 120 being formed of a flexible material; a second water-oxygen barrier film 340 located on one side of the second cover body 120 away from the first membrane 311; a second bonding layer 350 located on one side of the second water-oxygen barrier film 340 away from the second cover body 120; a decorative layer 360 located on one side of the second cover body 120 away from the first cover body, i.e., away from the first membrane 311 or the electronic device rear cover 310. The decorative layer 360 includes at least one of the following structures: a texture sub-layer, a coating sub-layer, a color sub-layer, and a bottom ink sub-layer. The provision of a decorative layer may result in a housing assembly with better visual effect and higher aesthetics. The first water-oxygen barrier film and the second water-oxygen barrier film are provided to isolate water and gas, reducing the damage to electronic components due to fluid leakage within the coolant flow path, and also reducing occurrence of a flow rate drop due to accumulation of air bubbles in the coolant flow path. Thus, the housing assembly with the aforementioned structure can be used directly as a cover body for the electronic device, thereby reducing an overall thickness of the electronic device and improving applicability of the housing assembly.

According to some embodiments of the present application, the type of adhesives in the first bonding layer and the second bonding layer is not particularly limited, for example, the first bonding layer and the second bonding layer can be an optical adhesive. The optical adhesive has characteristics of colorless and transparency, high light-transmission rate, good bonding strength, capability of being cured at room or medium temperature, small curing shrinkage, etc., which is helpful to form a housing assembly with good structural stability.

According to some embodiments of the present application, the thicknesses of the texture sub-layer, coating sub-layer, color sub-layer, and bottom ink sub-layer included in the decorative layer are not particularly limited. For example, a thickness of the texture sub-layer may range from 15 to 25 microns, a thickness of the coating sub-layer may range from 180 to 220 microns, and a thickness of the cover ink sub-layer may range from 15 to 25 microns.

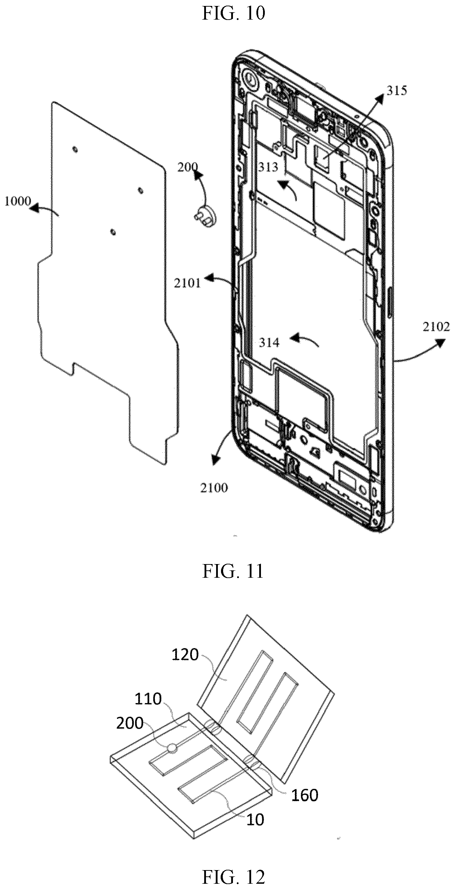

According to some embodiments of the present application, with reference to FIG. 11, a structure of the housing assembly is not particularly limited, for example, the housing assembly may have a frame structure with a liquid-cooling plate fixed to one side of the frame structure. Specifically, a middle frame 2100 of the electronic device may provide support and heat homogeneity for the device. A front side 2101 of the middle frame is bonded to a display via an adhesive, and a back side 2102 is bonded to a battery cover via an adhesive. A chip inside the electronic device is in soft contact or direct hard contact with a chip area 313 of the middle frame through a thermally conductive interface material. In order to ensure a small overall thickness of the electronic device, a battery area 314 of the middle frame can be hollowed. The pre-installed liquid-cooling plate 1000 of a piezoelectric ceramic pump 200 can be assembled with the middle frame 2100 by gluing, laser welding, snap or screw fixing, etc. The piezoelectric ceramic pump 200 can be arranged in a slot 315 reserved in the middle frame, thus not increasing a thickness of the electronic device.

According to some embodiments of the present application, a structure of the housing assembly is not particularly limited, for example, the liquid-cooling plate includes a folding portion, a first liquid-cooling section and a second liquid-cooling section, and the first liquid-cooling section and the second liquid-cooling section are connected to each other via the folding portion, and can be folded at the folding portion in the same direction as a rear cover of the electronic device. Thus, the housing assembly can be applied in a foldable device. Specifically, referring to FIG. 12, the first cover body 110 and the second cover body 120 can be folded together by a rotatable joint.

According to some embodiments of the present application, the piezoelectric ceramic pump may include: a piezoelectric diaphragm which includes a piezoelectric ceramic plate and a support plate in contact with the piezoelectric ceramic plate, a surface of the piezoelectric ceramic plate being provided with electrodes capable of generating an electric field which controls oscillation of the piezoelectric ceramic plate; and a valve body which is provided between the piezoelectric diaphragm and the liquid-cooling plate and located on the liquid-cooling plate. The piezoelectric diaphragm is located on one side of the valve body away from the liquid-cooling plate. The valve body includes a check valve cover and a check valve membrane. The check valve cover has a first through-hole and a second through-hole, the area of the first through-hole being larger than that of the second through-hole. The check valve membrane is located between the check valve cover and the liquid-cooling plate, and is configured to oscillate with oscillation of the piezoelectric ceramic plate. The check valve membrane has two skeletonized areas of the same shape, both having a solid portion. An orthographic projection of the solid portion is located at the first through-hole and the second through-hole. An orthographic projection of the first through-hole on the liquid-cooling plate fully covers one of the coolant inlet and the coolant outlet, an orthographic projection of the second through-hole on the liquid-cooling plate is located within the other one of the coolant inlet and the coolant outlet. An orthographic projection of the solid portion on the check valve upper cover corresponding to the second through-hole fully covers the second through-hole, an orthographic projection of the solid portion on the liquid-cooling plate corresponding to the first through-hole fully covers said one of the coolant inlet and the coolant outlet. The structure and operation of the piezoelectric ceramic pump in the housing assembly are similar to those of the piezoelectric ceramic pump in the aforementioned heat dissipation assembly, which have been described in detail earlier and will not be repeated here.

According to some embodiments of the present application, the coolant flow path may further include a blocking piece. The coolant inlet and the coolant outlet are provided adjacent to each other, and the blocking piece is located between the coolant inlet and the coolant outlet to divide the coolant flow path into a water supply area and a water return area. The water supply area is connected to the coolant inlet on one side, the water return area is connected to the coolant outlet, the water supply area and the water return area are connected on one side away from the coolant inlet. The blocking piece in the housing assembly is similar to that in the aforementioned heat dissipation assembly, which has been described in detail earlier and will not be repeated here.

According to some embodiments of the present application, the liquid-cooling plate may include a first cover body and a second cover body. The first cover body has a first recess on one side facing the second cover body, the second cover body has a second recess on one side facing the first cover body, and the first recess and the second recess form a coolant flow path. The first cover body or second cover body has a through-hole penetrating the cover body, the through-holes constituting a coolant inlet and a coolant outlet. A structure of the liquid-cooling plate in the housing assembly is similar to that of the liquid-cooling plate in the aforementioned heat dissipation assembly, which has been described in detail earlier and will not be repeated here.

According to some embodiments of the present application, the liquid-cooling plate may include a first cover body and a second cover body, with a spacer disposed between them. The spacer has a skeletonized pattern constituting a coolant flow path. The first cover body or the second cover body has two through-holes penetrating the cover body, with the through-holes constituting the coolant inlet and the coolant outlet. A structure of the liquid-cooling plate in the housing assembly is similar to that of the liquid-cooling plate in the aforementioned heat dissipation assembly, which has been described in detail earlier and will not be repeated here.

According to some embodiments of the present application, the liquid-cooling plate shall satisfy at least one of the following conditions: a volume of the piezoelectric ceramic pump and the coolant flow path is configured so that a flow rate of the coolant in the coolant flow path is not less than 0.5 mL/min; a depth of the coolant flow path is not less than 25 microns; and at least one of a thickness H and a diameter D of the piezoelectric ceramic sheet of the piezoelectric ceramic pump satisfies: 0.1 mm ≤ H ≤ 0.5 mm; 3 mm ≤ D ≤ 12 mm. Structural parameters of the liquid-cooling plate in the housing assembly are consistent with those of the liquid-cooling plate in the aforementioned heat dissipation assembly, which have been described in detail earlier and will not be repeated here.

For better understanding, a method for preparing the housing assembly described above in the present application will be briefly described below in connection with some specific embodiments. The method includes: providing a liquid-cooling plate, and arranging a piezoelectric ceramic pump on the liquid-cooling plate. As a result, a housing assembly with a coolant flow path therein, i.e., the aforementioned housing assembly, can be obtained through this method, and thus this method has all the features and advantages of the aforementioned housing assembly. The method for preparing a liquid-cooling plate and a piezoelectric ceramic pump in the housing assembly may be the same as the method for preparing a liquid-cooling plate and a piezoelectric ceramic pump in the heat dissipation assembly described above, that is, the method for preparing the housing assembly has all the features and advantages of the method for preparing the heat dissipation assembly described above. In general, the method can produce a housing assembly with good temperature homogeneity.

In particular, it shall be noted that in the preparation of the aforementioned housing assembly, there is no sequence between the steps of sealing a first cover body and a second cover body, and arranging a piezoelectric ceramic pump on the liquid-cooling plate, i.e., the first cover body and the second cover body are sealed first and then the piezoelectric ceramic pump is arranged on the liquid-cooling plate, or the piezoelectric ceramic pump is arranged on the first cover body or the second cover body first and then the first cover body and second cover body are sealed. The sequence can be chosen by those skilled in the art according to actual situations.

According to some embodiments of the present application, the method may further include: when the first cover body includes an electronic device rear cover and a first membrane, the first membrane and the second cover may first be sealed to obtain a coolant flow path; the first membrane and the second cover body are laminated to the electronic device rear cover to obtain a liquid-cooling plate; and then a piezoelectric ceramic pump is arranged on the liquid-cooling plate. According to some embodiments of this application, the way of laminating treatment is not particularly limited, for example, the laminating treatment may include at least one of roller lamination and press lamination. For example, when the electronic device rear cover is a flat glass rear cover, the roller lamination process can be used, where after the first membrane and the second cover body are laminated to the electronic device rear cover, the lamination process is carried out, and finally the piezoelectric ceramic pump is arranged on the liquid-cooling plate; for example, when the electronic device rear cover is 3D glass, the first film and the second cover body can be first laminated to an inner surface of the electronic device rear cover, and then a vacuum lamination jig is used for the laminating process, ensuring the lamination flatness.

According to some embodiments of the present application, the way of sealing the first membrane with the second cover body is not particularly limited, for example, the way of sealing the first membrane with the second cover body may include at least one of bonding and gluing.

According to some embodiments of the present application, when the first cover body includes an electronic device rear cover and a first membrane, the method may further include: providing an electronic device rear cover; affixing a first bonding layer to one side of the electronic device rear cover facing the first membrane; removing a release film of the first bonding layer on the side away from the electronic device rear cover; affixing a first water-oxygen barrier film to one side of the first membrane away from the second cover body; sealing the first membrane with the second cover body; affixing the first membrane and the second cover body on one side of the first water-oxygen barrier film away from the first bonding layer; arranging a piezoelectric ceramic pump on the liquid-cooling plate; affixing a second water-oxygen barrier film on one side of the second cover body away from the first membrane; affixing a second bonding layer on one side of the second water-oxygen barrier film away from the second cover body; removing a release film of the second bonding layer on the side away from the second water-oxygen barrier film; affixing a decorative layer on one side of the second cover body away from the first cover body, i.e., on the side away from the first membrane or the electronic device rear cover, and a lamination process is carried out from one side of the decorative layer away from the second bonding layer.

Through the aforementioned method, a housing assembly with a coolant flow path therein is obtained, i.e., the obtained housing assembly is the foregoing housing assembly, and therefore the method has all the features and advantages of the foregoing housing assembly. In general, the method can produce a housing assembly with fast heat dissipation, temperature homogeneity, and miniaturized size.

In a further aspect of the present application, the application proposes an electronic device, which includes: a housing assembly as described above, which defines an electronic device accommodation space; a battery; and a motherboard. The battery and the motherboard are placed inside the electronic device accommodation space defined by the housing assembly, the piezoelectric ceramic pump in the housing assembly is electrically connected to the motherboard, and the motherboard is electrically connected to the battery. Thus, the electronic device may have the aforementioned housing assembly with better temperature homogeneity, without local overheating during use, but with better user experience.

According to some embodiments of the present application, since the housing assembly has a piezoelectric ceramic pump, an external circuit is required to control operation of the piezoelectric ceramic pump. Therefore, electrodes in the piezoelectric ceramic pump of the housing assembly can be electrically connected to the motherboard; and specifically, the electrodes in the piezoelectric diaphragm of the piezoelectric ceramic pump capable of generating an electric field may be connected to the motherboard through an elastic metal piece. As a result, control of the piezoelectric ceramic pump can be easily achieved.

According to some embodiments of the present application, the coolant flow path on the liquid-cooling plate of the housing assembly is divided into a water supply area and a water return area, with one side of the water supply area being connected to the coolant inlet, and the water return area being connected to the coolant outlet. The piezoelectric ceramic pump has a pump-in port connected to the coolant outlet and a pump-out port connected to the coolant inlet. Specifically, the electronic device may further include a heat source chip, which is located on the side of the water supply area, and further, the heat source chip is located near the coolant inlet of the housing assembly. Heat generation of the electronic device mainly comes from the battery and chip on the motherboard. In general, the temperature in the areas of the battery and motherboard in the electronic device will be higher than in other areas; by arranging the aforementioned housing assembly on the electronic device, a cooling fluid in the coolant flow path of the water supply area inside the housing assembly can be used to quickly transfer heat from the heat source area, where the heat source chip is located, to the water return area, so as to achieve the effect of uniform heat and temperature. And, through the design of an internal coolant flow path of the housing assembly, it is possible to realize a customized distribution of the water supply area and the water return area on the basis of simple heat homogeneity. That is, through the design of direction and location of the coolant flow path, as well as a reasonable layout, the temperature at locations where the user is not easy to contact in use may be increased, and the temperature at locations frequently contacted may be decreased. Thus, the electronic device, having the aforementioned housing assembly with better temperature homogeneity, will not experience local overheating during use, and its user experience will be better.

According to embodiments of the present application, a specific location of the housing assembly in the electronic device is not particularly limited, for example, the housing assembly can be provided inside the electronic device, such as between the battery and the screen. Alternatively, the housing assembly may be provided at a housing of the electronic device. The housing assembly has self-supporting properties and is relatively thin, so that the location can be reasonably designed according to internal components of the electronic device, and can be selected by those skilled in the art according to actual situations.

In the description of the present application, orientation or positional relationships indicated by terms "up", "down", etc. are based on the orientation or positional relationships shown in the accompanying drawings, and are intended only to facilitate description of the present application, but not to require that the present application must be constructed and operated in a particular orientation, and thus cannot be construed as limiting the application.

In the description of this specification, reference to terms "an embodiment", "another embodiment", etc. means that specific features, structures, materials or properties described in connection with an embodiment are included in at least one embodiment of the present application. In this specification, schematic expressions of the above terms must not be directed to the same embodiment or example. Moreover, the specific features, structures, materials, or characteristics described may be combined in any one or more embodiments or examples in a suitable way. In addition, without contradicting each other, those skilled in the art may combine different embodiments or examples described in this specification, or those features of different embodiments or examples. In addition, it shall be noted that the terms "first", "second" are used in this specification for descriptive purposes only, and shall not be construed as indicating or implying relative importance or the number of technical feature.

Although embodiments of the present application have been shown and described above, it is understood that the above embodiments are exemplary and shall not be construed as limitation on the application, and that variations, modifications, replacements and variants of the above embodiments may be made by those of ordinary skill in the art within the scope of the present application.

## Claims

1. A heat dissipation assembly, comprising:
a liquid-cooling plate having a coolant flow path inside the liquid-cooling plate, with a cooling fluid sealed inside the liquid-cooling plate, the liquid-cooling plate having a coolant inlet and a coolant outlet in communication with the coolant flow path; and
a piezoelectric ceramic pump provided on the liquid-cooling plate and communicated with the coolant flow path, the piezoelectric ceramic pump having a pump-in port connected to the coolant outlet and a pump-out port connected to the coolant inlet.

2. The heat dissipation assembly of claim 1, wherein the piezoelectric ceramic pump comprises:
a piezoelectric diaphragm comprising a piezoelectric ceramic sheet and a support plate in contact with the piezoelectric ceramic sheet, a surface of the piezoelectric ceramic sheet being provided with electrodes capable of generating an electric field which controls the piezoelectric ceramic sheet to oscillate; and
a valve body provided between the piezoelectric diaphragm and the liquid-cooling plate, the valve body being capable of controlling one of the pump-in port and pump-out port to be open, and the other one to be closed.

3. The heat dissipation assembly of claim 2, wherein the valve body is located on the liquid-cooling plate and the valve body comprises a check valve upper cover and a check valve membrane; the check valve upper cover has a first through-hole and a second through-hole, the area of the first through-hole being larger than that of the second through-hole; the check valve membrane is located between the check valve upper cover and the liquid-cooling plate, and is configured to oscillate with oscillation of the piezoelectric ceramic sheet; the check valve membrane has two skeletonized areas of the same shape both having a solid portion, an orthographic projection of the solid portion on the check valve upper cover being located at the first through-hole and the second through-hole,
and, an orthographic projection of the first through-hole on the liquid-cooling plate fully covers one of the coolant inlet and the coolant outlet, an orthographic projection of the second through-hole on the liquid-cooling plate is located within the other one of the coolant inlet and the coolant outlet,
and, an orthographic projection of the solid portion on the check valve upper cover corresponding to the second through-hole fully covers the second through-hole, an orthographic projection of the solid portion on the liquid-cooling plate corresponding to the first through-hole fully covers said one of the coolant inlet and the coolant outlet.

4. The heat dissipation assembly of claim 1, wherein the coolant inlet is adjacent to the coolant outlet, and a blocking piece is provided between the coolant inlet and the coolant outlet.

5. The heat dissipation assembly of claim 1, wherein a volume of the piezoelectric ceramic pump and the coolant flow path is configured so that a flow rate of the coolant in the coolant flow path is not less than 0.5 mL/min.

6. The heat dissipation assembly of claim 5, wherein at least one of the following conditions is met:
a depth of the coolant flow path is not less than 25 microns; and
at least one of a thickness H and a diameter D of the piezoelectric ceramic sheet in the piezoelectric ceramic pump satisfies: 0.1mm ≤ H ≤ 0.5mm; 3mm ≤ D ≤ 12mm.

7. The heat dissipation assembly of claim 1, wherein the coolant flow path has a buffer section adjacent to the coolant inlet and the coolant outlet, and a width of the coolant flow path at the buffer section is greater than that of the coolant flow path at a non-buffer section.

8. The heat dissipation assembly of any of claims 1-7, wherein the liquid-cooling plate comprises a first cover body and a second cover body opposite to each other, with the coolant flow path being sealed between the first cover body and the second cover body,
a material forming the first cover body and the second cover body comprises at least one of polyester, polyimide, polymethyl methacrylate, polyethylene, polyvinyl chloride, polystyrene, ceramic, and glass, respectively.

9. The heat dissipation assembly of claim 8, wherein the first cover body has a first recess on a side facing the second cover body, the second cover body has a second recess on a side facing the first cover body, and the first recess and the second recess form the coolant flow path,
the first cover body or the second cover body has a through-hole penetrating there-through, the through-hole constituting the coolant inlet and the coolant outlet.

10. The heat dissipation assembly of claim 8, wherein a surface of one of the first cover body and the second cover body is provided with a recess, and the recess and the other one of the first cover body and the second cover body form the coolant flow path.

11. The heat dissipation assembly of claim 8, wherein a spacer is provided between the first cover body and the second cover body, the spacer having a skeletonized pattern which constitutes the coolant flow path,
the first cover body or the second cover body has two through-holes penetrating the cover body, the through-holes constituting the coolant inlet and the coolant outlet.

12. The heat dissipation assembly of claim 8, wherein at least one of the first cover body and the second cover body is formed of a flexible material,
the heat dissipation assembly further comprises a water-oxygen barrier film located on one side of the cover body formed of the flexible material away from the coolant flow path.

13. A housing assembly, comprising:
a liquid-cooling plate comprising a first cover body and a second cover body with a coolant flow path there-between, a cooling fluid being sealed inside the coolant flow path, the liquid-cooling plate having a coolant inlet and a coolant outlet in communication with the coolant flow path; and
a piezoelectric ceramic pump provided on the liquid-cooling plate and communicated with the coolant flow path, the piezoelectric ceramic pump having a pump-in port connected to the coolant outlet and a pump-out port connected to the coolant inlet.

14. The housing assembly of claim 13, wherein the housing assembly is applicable in an electronic device, the first cover body comprises an electronic device rear cover and a first membrane, and the coolant flow path is defined between the first membrane and the second cover body.

15. The housing assembly of claim 14, wherein the housing assembly further comprises at least one of the following structures:
a first water-oxygen barrier film located on one side of the first membrane away from the second cover body;
a second water-oxygen barrier film located on one side of the second cover body away from the first membrane;
a decorative layer located on one side of the second cover body away from the first cover body, the decorative layer comprising at least one of: a texture sub-layer, a coating sub-layer, a color sub-layer, and a bottom ink sub-layer.

16. The housing assembly of any of claims 13-15, wherein the liquid-cooling plate comprises a folding portion, a first liquid-cooling portion and a second liquid-cooling portion, wherein the first liquid-cooling portion and the second liquid-cooling portion are connected via the folding portion.

17. The housing assembly of any of claims 13-15, wherein the piezoelectric ceramic pump comprises:
a piezoelectric diaphragm comprising a piezoelectric ceramic sheet and a support plate in contact with the piezoelectric ceramic sheet, a surface of the piezoelectric ceramic sheet being provided with electrodes capable of generating an electric field which controls the piezoelectric ceramic sheet to oscillate; and
a valve body provided between the piezoelectric diaphragm and the liquid-cooling plate and located on the liquid-cooling plate, wherein the piezoelectric diaphragm is located on one side of the valve body away from the liquid-cooling plate, the valve body comprises a check valve upper cover and a check valve membrane, the check valve upper cover has a first through-hole and a second through-hole, the area of the first through-hole being larger than that of the second through-hole, the check valve membrane is located between the check valve upper cover and the liquid-cooling plate, and is configured to oscillate with oscillation of the piezoelectric ceramic sheet, the check valve membrane has two skeletonized areas of the same shape both having a solid portion, an orthographic projection of the solid portion on the check valve upper cover being located at the first through-hole and the second through-hole,
and, an orthographic projection of the first through-hole on the liquid-cooling plate fully covers one of the coolant inlet and the coolant outlet, an orthographic projection of the second through-hole on the liquid-cooling plate is located within the other one of the coolant inlet and the coolant outlet,
and, an orthographic projection of the solid portion on the check valve upper cover corresponding to the second through-hole fully covers the second through-hole, an orthographic projection of the solid portion on the liquid-cooling plate corresponding to the first through-hole fully covers said one of the coolant inlet and the coolant outlet.

18. The housing assembly of any of claims 13-15, wherein,
a depth of the coolant flow path is not less than 25 microns; and
at least one of a thickness H and a diameter D of the piezoelectric ceramic sheet of the piezoelectric ceramic pump satisfies: 0.1mm ≤ H ≤ 0.5mm; 3mm ≤ D ≤ 12mm.

19. An electronic device, comprising:
the housing assembly of any of claims 13-18, the housing assembly defining an electronic device accommodation space;
a battery; and
a motherboard,
wherein the battery and the motherboard are located inside the electronic device accommodation space, the motherboard is electrically connected to the battery, and the piezoelectric ceramic pump in the housing assembly is electrically connected to the motherboard.

20. The electronic device of claim 19, further comprising a heat source chip which is located near the coolant inlet in the housing assembly.
